Europäisches Patentamt

European Patent Office

Office européen des brevets

(11) Veröffentlichungsnummer: **0 173 643**
A2

(12) # EUROPÄISCHE PATENTANMELDUNG

(21) Anmeldenummer: 85730114.7

(22) Anmeldetag: 27.08.85

(51) Int. Cl.⁴: **H 01 L 29/267,** H 01 L 29/40, H 01 L 33/00

(30) Priorität: 31.08.84 DE 3432603

(43) Veröffentlichungstag der Anmeldung: 05.03.86 Patentblatt 86/10

(84) Benannte Vertragsstaaten: AT BE CH DE FR GB IT LI LU NL SE

(71) Anmelder: Heinrich-Hertz-Institut für Nachrichtentechnik Berlin GmbH, Einsteinufer 37, D-1000 Berlin 10 (DE)

(72) Erfinder: Grote, Norbert, Dr.-Ing., Angerburger Allee 15, D-1000 Berlin 19 (DE)
Erfinder: Su, Li-man, Dr.-Ing., c/o Beijing Electron Tube Factory P.O. Box 23, Beijing (CN)

(74) Vertreter: Wolff, Konrad, Heinrich-Hertz-Institut für Nachrichtentechnik Berlin GmbH Einsteinufer 37, D-1000 Berlin 10 (DE)

(54) Halbleiterbauelement, das eine Schicht aus transparentem, n-leitenden Material aufweist, und Verwendung derartiger Bauelemente.

(57) Halbleiterbauelemente, die eine Schicht aus transparentem, n-leitendem Material aufweisen, welches optisch transparent, elektrisch leitfähig – n-leitend – und polykristallin bis amorph ist, werden insbesondere für die Verwendung in der optischen Nachrichtentechnik, für die sich zunehmend der Einsatz monomodaler Systeme abzeichnet, sowohl als elektronische als auch als optoelektronische Bauelemente und Schaltungen, vorzugsweise auch in monolithischer Integration benötigt.

Auf der Basis von III-V-Material – InP, InGaAs, InGaAsP – sind erfindungsgemäss Bauelemente unterschiedlicher Art, z. B. pn-Dioden, Bipolartransistoren, Photodioden, Lumineszenzdioden, Laser – nach einem weitgehend einheitlichen Technologiekonzept, das verhältnismässig geringen Aufwand erfordert, mit anderen Prozessschritten kompatibel ist, keine Anpassung von Kristall-Gitterkonstanten erfordert u.v.m., mit mindestens einer Schichtenfolge aufzubauen, in der eine p- oder n-dotierte Halbleiterschicht mit transparentem, n-leitendem, polykristallinem bis amorphem Oxidmaterial – vorzugsweise CdO, Cd(Sn)O, In₂(Sn)O₃ – einen pn-Übergang bzw. einen quasi-ohmschen Kontakt bilden.

0173643

HEINRICH-HERTZ-INSTITUT FÜR NACHRICHTENTECHNIK BERLIN
GMBH                                          11/0884 EP

Halbleiterbauelement, das eine Schicht aus transparentem, n-leitendem Material aufweist, und Verwendung derartiger Bauelemente

Die Erfindung betrifft das Gebiet der optischen Nachrichtentechnik und bezieht sich auf Halbleiterbauelemente, die eine Schicht aus einem Material aufweisen, welches optisch transparent, elektrisch leitfähig - n-leitend - und polykristallin bis amorph ist, sowie auf die Verwendung derartiger Bauelemente.

In der optischen Nachrichtentechnik zeichnet sich zunehmend der Einsatz monomodaler Systeme ab. Dabei werden sowohl optoelektronische als auch elektronische Bauelemente und Schaltungen, insbesondere auch in monolithischer Integration, benötigt.

Auf ein spezielles Bauelement, das eine Elektrode aus transparentem Material nach Art eines oxidunterstützten Schottky-Kontaktes aufweist, und über das im Rahmen einer Tagung vom 28. bis 30. März 1983 (2$^{nd}$ NATO Workshop "Material Aspect of InP", Lancaster, UK, März 1983) berichtet worden ist, bezieht sich eine Patentanmeldung beim DPA, DE-OS 33 11 511 bzw. entsprechende Nachanmeldungen z.B. beim EPA: 84 730 027 vom 23. März 1984, veröffentlicht am 31.10.84, EP-A-0123644.
Bei diesem Bauelement wird auf die Eigenschaften eines "Quasi-Schottky"-Überganges abgestellt, wobei negative Ladungsträger (Elektronen) nur von der Halbleiterschicht in das elektrisch leitende bzw. hier in die sich elektrisch ähnlich einem Metall verhaltende Cadmiumoxidschicht injiziert werden, nicht jedoch umgekehrt. Vor allem wird bei diesem Übergang auch von dem Sperrverhalten in Rückwärtsrichtung Gebrauch gemacht.

0173643

Die Verwendung und der Einsatz von transparentem, elektrisch leitfähigem Material für elektronische und optische Bauelemente und andere Erzeugnisse ist in großer Vielfalt bekannt. Dabei sind im wesentlichen die Volumeneigenschaften von Schichten aus transparentem, elektrisch leitendem Material von Bedeutung. In "Thin Solid Films" 102(1983), Seiten 1 bis 46, wird ein umfassender Überblick hierzu gegeben. Dabei werden für nicht-stöchiometrische und dotierte Oxidmaterialien auf Zinn-, Indium-, Cadmium- und Zinkbasis, einschließlich mehrerer verschiedener Verbindungen, zahlreiche Depositionstechniken sowie die damit verbundenen Beeinflussungsmöglichkeiten der Volumen-, insbesondere der elektrischen und optischen Eigenschaften dieser Materialien behandelt.

Insbesondere für Cadmium-Zinn-Oxid (CTO) wird in "Applied Physics Letters", 35(7), 1. Okt.1979, Seiten 542/543 und 37(2), 15. Jul. 1980, Seiten 180/181 über die Herstellung von entsprechenden Oxidschichten berichtet, und zwar über Sputterprozesse, die sich insbesondere im Vergleich zu Epitaxieverfahren mit geringerem technischen Aufwand durchführen lassen.

Der Erfindung liegt die Aufgabe zugrunde, insbesondere für das eingangs schon erwähnte Gebiet der optischen Nachrichtentechnik bezüglich der dort für Monomodesysteme im bevorzugten Wellenlängenbereich einsetzbaren Materialien den Aufbau und die Ausbildung von Bauelementen unterschiedlicher Art, auch in monolithischen Schaltungen, nach einem möglichst einheitlichen, geringen Aufwand erfordernden Technologiekonzept zu ermöglichen. Für derartige Bauelemente sind vor allem auch die elektronischen Eigenschaften der Grenzflächen in Heteroverbindungen von Bedeutung.

Gelöst wird diese Aufgabe für die im Oberbegriff des Anspruches 1 angegebenen Bauelemente erfindungsgemäß durch mindestens eine Schichtenfolge, in der eine monokristalline, p- oder n-dotierte Schicht aus InP-, InGaAs- oder InGaAsP-Halbleitermaterial und die Schicht aus dem optisch transparenten, n-leitenden Material einen pn-Übergang bzw. einen quasi-ohmschen Kontakt bilden.

Dabei ist zunächst von wesentlicher Bedeutung, daß bei den betreffenden Oxidmaterialien der für die gewünschten Bauelemente erforderliche Bandabstand vorhanden ist und Elektronen aus diesem Oxidmaterial in benachbarte, p-dotierte Halbleiterschichten injiziert werden können, d.h. Schichten aus derartigem Oxid-Material wie eine n-leitende Halbleiterschicht wirken bzw. derartigem Oxidmaterial elektronische Halbleitereigenschaften zugeschrieben werden können. Für opto-elektronische Bauelemente bieten weiterhin die optischen Eigenschaften dieser Oxidmaterialien (Transparenz, Brechungsindex u.a.), verbunden mit den oben genannten elektronischen Halbleitereigenschaften, hervorragende Voraussetzungen für den Einsatz solchen Materials. Besondere und ganz erhebliche Vorteile liegen jedoch auf verfahrenstechnischem Gebiet: derartiges Oxidmaterial kann in sogenannten "kalten" Prozessen, insbesondere schon bei Temperaturen unterhalb von 150 $^\circ$C aufgebracht werden, erlaubt mit photolithographischen Lacken kompatible Prozeßschritte, speziell auch die Anwendung von sogenannten "lift off"-Strukturierungs- schritten. Es ist keine Gitteranpassung zwischen den betreffenden Materialschichten erforderlich (wie bei Epitaxieverfahren), vielmehr darf das Oxidmaterial ohne weiteres im Hinblick auf die gewünschten Eigenschaften polykristallin bis amorph sein. Damit lassen sich z.B. von Silizium-Bauelementen her bekannte Planartechnologien auf das hier eingesetzte III-V-Material teilweise weitgehend übertragen sowie mit anderen Prozessen für die Herstellung von Hetero-Verbindungen, z.B. Epitaxie-, Diffusions- und Implantationsverfahren, verbundene nachteilige Auswirkungen, insbesondere durch hohe Temperaturen hervorgerufene Beeinflussungen bereits fertiggstellter Strukturen vermeiden.

Die bevorzugten Ausführungsformen der Erfindung lassen sich von der bestimmungsgemäßen Betriebsart der betreffenden Bauelemente her unterscheiden. Zu den Bauelementen, die einen in Vorwärtsrichtung gepolten pn-Übergang aufweisen, gehören pn-Dioden, vorzugsweise auch Elektrolumineszenzdioden - LED's - und elektrisch oder optisch ansteuerbare Bipolartransistoren, bei denen insbesondere das Emittergebiet von der n-leitenden Schicht aus dem optisch transparenten, polykristallinen bis amorphen Material gebildet werden kann.

Mit in Sperrichtung gepolten pn-Übergängen können Photodioden sowie ebenfalls elektrisch oder optisch ansteuerbare Bipolartransistoren, bei diesen dann insbesondere mit dem Kollektorgebiet aus der n-leitenden Schicht des optisch transparenten, polykristallinen bis amorphen Materials, aufgebaut werden.

Zu Bauelementen mit einem nicht vorgespannten pn-Übergang gehören insbesondere photovoltaische Elemente.

Es können auch mehrere Schichtenfolgen der erfindungsgemäßen Art in einem einzelnen Bauelement vorhanden
sein. Dabei können pn-Übergänge mit entsprechender oder
ohne Polung sowie nn-Übergänge, in Form quasi-ohmscher Kontakte vorliegen. Hierzu gehören z.B. Lumineszenzdioden
und Laser mit Confinement-Schichten aus dem n-leitenden,
transparenten Material,   die gegebenenfalls auch noch
ein Rückkopplungsgitter beinhalten können, sowie
optische Durchgangsverstärker.

Wird bei Ausführungsformen der Erfindung die Schicht
aus dem Oxidmaterial als Antireflexionsschicht eingesetzt, können die elektronischen Eigenschaften der
Grenzfläche dieser Schicht zu einer benachbarten Halbleiterschicht beliebiger Art sein, d.h. also insbesondere als pn-Übergänge mit entsprechender Polung oder
auch als nn-Übergang vorliegen.

Als besonders bevorzugte Oxidmaterialien haben sich
für Ausführungsformen der Erfindung Cadmiumoxid, Cadmiumzinnoxid und Indiumzinnoxid herausgestellt. Mit diesen Materialien wird einerseits für den gewünschten
Wellenlängenbereich eine verhältnismäßig hohe optische
Transparenz und andererseits eine ebenfalls hohe, gegebenenfalls auch auf einfache Weise verringerbare elektrische Leitfähigkeit erzielt. Bezüglich der Auswahl
des Oxidmaterials entsprechend den jeweils geforderten
optischen und elektronischen Eigenschaften stehen dem
auf diesem Gebiet tätigen Fachmann weitere Materialien
und insbesondere auch betreffende Informationen zur
Verfügung, von denen im Bedarfsfall ohne weiteres Gebrauch gemacht werden kann.

Die verfahrenstechnischen Voraussetzungen für die Ausbildung der einzelnen erfindungsgemäßen Bauelemente ermöglichen auf besonders vorteilhafte Weise deren Verwendung für den Aufbau elektronischer und/oder optoelektronischer integrierter Schaltungen, insbesondere für deren Einsatz in optischen Nachrichtensystemen. Dort können Silizium- oder Germanium-Bauelemente nur eingesetzt werden, sofern diese Bauelemente keine optischen Eigenschaften aufweisen müssen, ausgenommen photodetektierende Bauelemente. Lassen sich die geforderten elektrischen Eigenschaften hingegen auch mit Bauelementen auf der Basis von III-V-Material für rein elektronische Funktionen ebenfalls erzielen, ist diesen im Hinblick auf die Integrierbarkeit in EOIC's (electrooptical integrated circuits) der Vorzug zu geben.

In der Zeichnung sind Ausführungsformen der Erfindung schematisch dargestellt. Dabei wird jeweils der Aufbau aus den einzelnen Schichten gezeigt, und zwar in

Fig. 1: für eine pn-Diode;

Fig. 2: für ein photovoltaisches Element;

Fig. 3: für eine erste Ausführungsform eines Bipolartransistors;

Fig. 4: für eine weitere Ausführungsform eines Bipolartransistors;

Fig. 5: für einen Laser;

Fig. 6: für einen DFB-Laser

und Fig. 7: für eine monolithische Integration eines Lasers und eines Transistors.

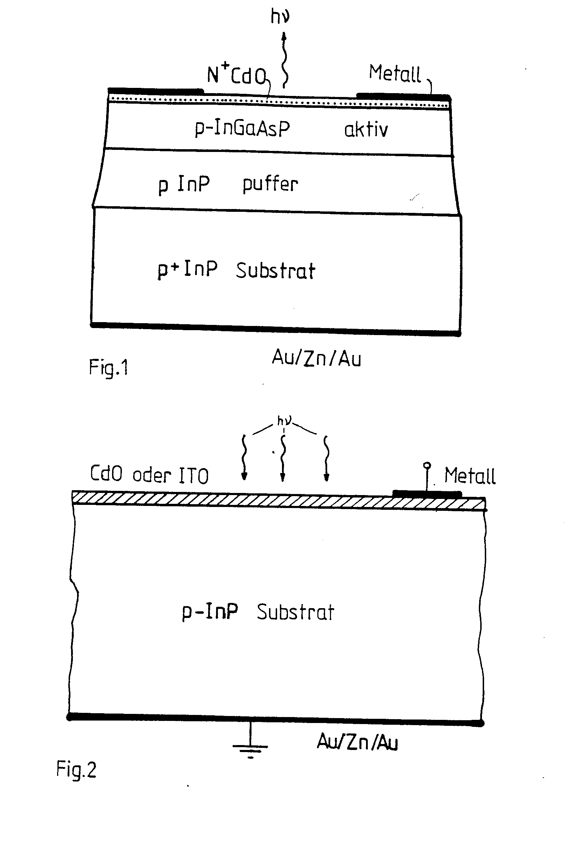

Die in Fig. 1 dargestellte pn-Diode besteht zunächst aus einem p-dotierten InP-Substrat mit einem Rückkontakt aus Au/Zn/Au auf der Unterseite, einer ebenfalls p-dotierten InP-Puffer- oder Bufferschicht und der lichtemittierenden InGaAsP-Schicht, deren Materialzusammensetzung die Wellenlänge der Lichtemission bestimmt. Die beiden p-dotierten Schichten werden in konventioneller Weise epitaktisch aufgewachsen. Anschließend wird vor dem Aufsputtern der CdO-Schicht die Schichtoberfläche durch naßchemisches Ätzen, z.B. mit HF : $H_2O$ (1 : 50) bzw. $H_2SO_4$ : $H_2O$ : $H_2O_2$ (1 : 1 : 1) oder durch Ionenbeschuß gereinigt. Die Dicke der CdO-Schicht kann so auf die Emissionswellenlänge abgestimmt werden, daß sie eine reflexionsmindernde Wirkung besitzt. Dadurch läßt sich die externe optische Quantenausbeute erhöhen. Die CdO-Schicht bildet mit der p-InGaAsP-Schicht einen pn-Übergang, sodaß bei Polung in Flußrichtung Elektronen aus dem CdO in das InGaAsP injiziert werden und dort durch strahlende Rekombination Elektrolumineszenz erzeugen. Wegen der hohen Dotierung der CdO-Schicht (etwa 2...3 Größenordnungen über der p-Dotierung) und eines genügend großen Bandabstandes kann man davon ausgehen, daß der Diodenstrom fast gänzlich durch Elektronendiffusion getragen wird, während die Löcherdiffusion in entgegengesetzter Richtung zu vernachlässigen ist. Das heißt, die CdO-Schicht wirkt als sogenannter "Wide-gap"-Elektronenemitter: Die laterale Strukturierung der Diode erfolgt a) durch naßchemisches Ätzen der CdO-Schicht mit z.B. HF : $H_2O$ (1 : 1000) oder b) durch Verwendung einer photolithographischen Abhebetechnik.

Um einen Bondanschluß mit niedrigem Kontaktwiderstand zu erzielen, wird auf die CdO-Schicht eine Metallisierungsschicht aus z.B. Al, Au-Ti oder Au-Cr aufgebracht. Diese Metallisierung bedeckt die CdO-Schicht für die Anwendung als rein elektrische pn-Diode ganzflächig;

bei Ausbildung als LED wird ein Fenster für den Lichtaustritt ausgespart. Es wurden Übergangswiderstände zwischen den Metallen und dem CdO von bis zu $2 \times 10^{-6}$ $\Omega cm^2$ gemessen.

Eine Temperung, z.B. in $N_2$, kann nach Fertigstellung der Diodenstruktur erfolgen, um sowohl den pn-Übergang (n-Faktor) und den Metall/CdO-Übergangswiderstand zu verbessern (Tempertemperaturen unterhalb von 400 $^\circ$C).

Entsprechend dem in Fig. 1 dargestellten Bauelement kann ein solches bei Vorspannung in Rückwärtsrichtung als Photodiode eingesetzt werden. Die Herstellung entspricht der einer LED. Als lichtabsorbierende Schicht dient die obere Epitaxieschicht, die etwa 3 - 5 µm dick ist und niedrig p-dotiert ist. Sie besteht vorzugsweise aus $In_{0,53}Ga_{0,47}As$ und absorbiert Lichtwellen in dem für die optische Nachrichtentechnik interessierenden Bereich von $\lambda = 1,3$ µm...1,55 µm. Der Lichteintritt in die absorbierende Schicht erfolgt durch die unbedeckte CdO-Schicht, die als Antireflexionsschicht ausgebildet werden kann.

Für die Herstellung einer LED wird auf dem p-Halbleiter, z.B. p-InP-Substrat oder eine p-dotierte Epitaxieschicht aus InGasAs(P), nach einem Reinigungsschritt, z.B. naßchemisch oder durch Sputterätzen mit $Ar/O_2$-Gas, die CdO-Schicht aufgesputtert (Hochfrequenzsputtern: 13,56 MHz, Ar-Plasma, Druck z.B. $8 \times 10^{-3}$ mbar, Rate $\simeq 2$ Å/sec). Anschließend wird mit einem Lift-off-Verfahren eine strukturierte Metallschicht aufgedampft, um das Aufbonden von Anschlußdrähten zu ermöglichen und den elektrischen Anschlußwiderstand zu reduzieren.

Eine seitliche elektrische Isolierung kann durch eine Isolationsschicht z.B. aus $SiO_2$, $Al_2O_3$, $Si_3N_4$ erfolgen (planare Diode). Die Ätzung des CdO zur Begrenzung der Diodenfläche erfolgt naßchemisch mit in $H_2O$ verdünnter Flußsäure (HF : $H_2O$ = 1 : 1000 vol %). Die Dicke der CdO-Schicht kann so auf die Emissionswellenlänge eingestellt werden, daß sie als Antireflexionsschicht dient und damit die äußere Lichtausbeute erhöht.

Die in Fig. 2 gezeigte CdO/p-Halbleiter-Diode wird ohne äußere Vorspannung als photovoltaisches Element (IV. Quadrant des I-V-Feldes) betrieben. Der Aufbau entspricht prinzipiell dem der Photodiode gemäß Fig. 1, ebenso das Herstellungsverfahren. Die CdO-Schicht läßt sich als Anti-Reflexionsschicht insbesondere für ausgewählte Wellenlängen durch geeignete Wahl der Dicke d ausbilden (d etwa $\lambda/4$). Entsprechend den Brechzahlen der begrenzenden Medien lassen sich dadurch für einen spezifischen Wellenlängenbereich Reflexionen verhindern bzw. zumindest reduzieren.

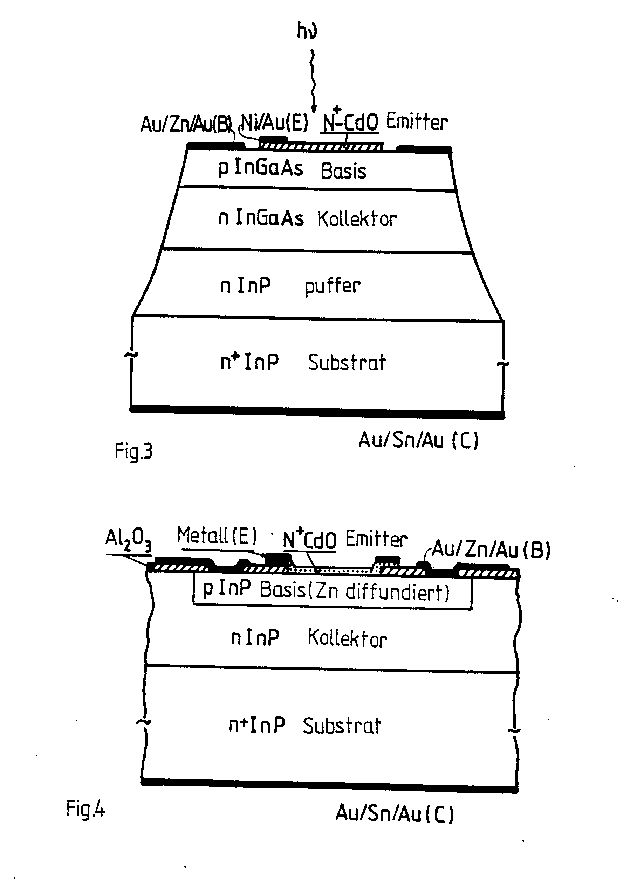

Ein gemäß Fig. 3 vertikal aufgebauter Bipolartransistor (npn) enthält eine n-dotierte InP-Pufferschicht, eine $n^-$-InGaAs-Kollektorschicht C , eine p-dotierte InGaAs-Basisschicht B sowie eine CdO-Schicht als Emitter E . Zunächst wird auf der Basisschicht der Basisanschluß-Kontakt(B)hergestellt aus z.B. Au/Zn/Au, sodann nach einer naßchemischen oder trockenchemischen (Ionenbeschuß) Oberflächenpräparation die CdO-Schicht aufgesputtert, die wiederum durch naßchemisches Ätzen (verdünnte HF-Lösung) oder durch Abhebeverfahren lateral strukturiert wird. Anschließend wird eine Metallschicht aus Ni/Au ganzflächig - für elektrische Transistoren - oder teilweise - für Phototransistoren - auf die CdO-Schicht aufgedampft, um einen geringen Emitteranschlußwiderstand zu erzielen. Die hohe Dotierung sowie der hohe Bandabstand (> mind. 1,25 eV) des CdO bedeuten, daß das CdO einen "Wide gap"-Emitter darstellt und ein nahezu idealer Emitterwirkungsgrad $\eta = 1$ erwartet werden kann. Zusätzlich wird dadurch eine hohe Basisdotierung ermöglicht.

Für die Ausbildung als Phototransistor ist der CdO-Emitter wegen seiner optischen Transparenz für die Lichteinstrahlung, ähnlich wie bei der Photodiode, vorteilhaft. Der Transistor kann als Mesa-Transistor oder als planares Bauelement ausgeführt werden. Dabei ist die geringe Dicke der CdO-Schicht, ca. 0,1...0,3 µm, ein deutlicher Vorteil gegenüber bisherigen III-V-Bipolartransistoren, deren Emitterschicht ebenfalls aus einer Epitaxieschicht besteht, die jedoch üblicherweise ca. 1 µm oder mehr dick ist. Außerdem erfolgt bei dieser Ausführungsform der Erfindung die Herstellung der CdO-Emitter-Schicht nach der Herstellung der Basiskontakte, so daß im Vergleich zu herkömmlichen III-V-Bipolartransistoren die dort notwendige, kritische Emitter-Mesa-Ätzung hier entfällt.

Eine andere Ausführungsform eines Bipolartransistors mit CdO-Emitter ist in Fig. 4 dargestellt. Diese Struktur besteht aus nur einer als Kollektorschicht C dienenden, n-dotierten Expitaxieschicht auf einem $n^+$-dotierten Substrat (InP), auf dessen Unterseite der Kollektorkontakt (C) aus Au/Sn/Au aufgebracht ist. Zunächst wird durch selektive Zn-Diffusion in der Epitaxieschicht ein p-dotierter Basisbereich B erzeugt, auf dem dann die Basiskontakte (B) aus Au/Zn/Au hergestellt werden. Die Emitterherstellung erfolgt wie bei Fig. 3 beschrieben. Die nicht kontaktierten Bereiche werden durch eine Isolatorschicht (z.B. $SiO_2$, $Al_2O_3$,

0173643

$Si_3N_4$) passiviert. Ein Temperschritt (T < 400 $^\circ$C) kann die Emitterinjektion sowie den Emitter-Metallisierungswiderstand verbessern. Die Struktur dieses planaren Bi- polartransistors entspricht weitgehend der üblichen Planartechnologie zur Herstellung bipolarer Si-Transistoren, mit der Ausnahme, daß anstelle der dort verwendeten Emitterdiffusion hier z.B. ein aufgesputterter CdO-Kontakt verwendet wird. Eine Anwendung eines solchen Emitters auf Si-Transistoren erlaubt übrigens die Verwendung eines "Wide-gap"-Emitters mit der Möglich- keit, eine hohe Dotierung der Basisschicht zur Verringerung des Basiswiderstandes einzustellen.

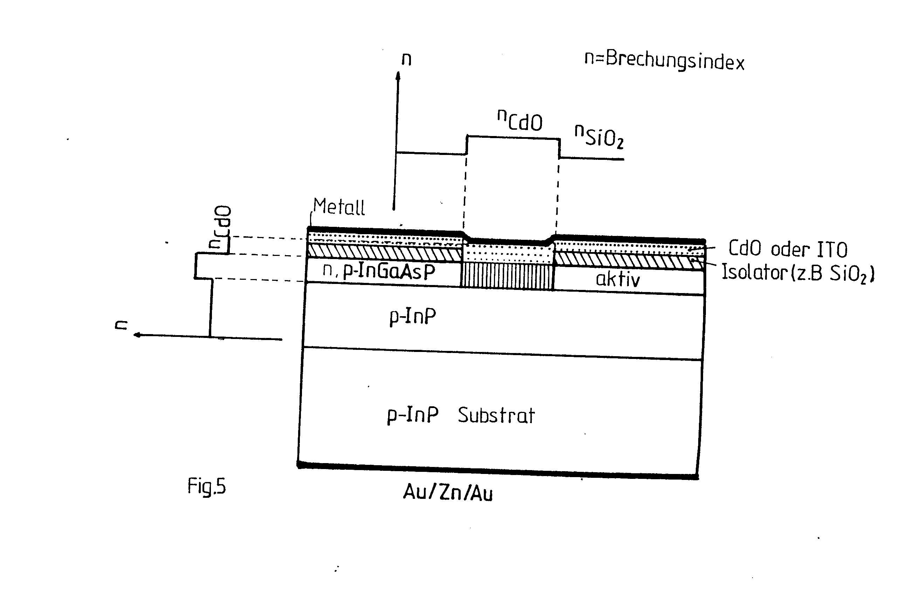

Wie Fig. 5 zeigt, kann bei Ausführungsformen der Erfindung im Gegensatz zur üblichen Doppelheterostruktur (DH) von Halbleiterlasern eine der beiden Schichten, die zum Confinement die aktive Schicht umgeben, z.B. aus CdO hergestellt werden. Dies ist möglich, weil CdO einerseits zur Erzeugung des elektrischen Confinements einen deutlich höheren Bandabstand besitzt als übliche Halbleitermaterialien für 1,3 - 1,5 µm-Laser, insbe- sondere als InGaAsP, und zum anderen zur Erzeugung des optischen Confinements auch einen genügend niedrigeren optischen Brechungsindex n aufweist. Dieser beträgt für CdO etwa 2, im Vergleich dazu für InGaAsP mehr als 3. Die Struktur wird auf einem hoch p-dotierten InP-Substrat, mit dem Rückkontakt aus Au/Zn/Au auf der Unterseite, durch Aufwachsen der unteren p-dotierten InP- Schicht sowie der aktiven InGaAsP-Schicht gebildet. Danach wird die Struktur mit einem Isolator, z.B. $SiO_2$, bedeckt, in die längs des Lasers ein Streifen geätzt wird. Anschließend wird nach bereits oben beschriebener Oberflächenpräparation ganzflächig die CdO- oder ITO-Schicht sowie eine Metallisierungsschicht aufgebracht. Die Differenz zwischen

den Brechungsindizes von $SiO_2$ und CdO führt zu einem effektiven Brechungsindexverlauf, der eine laterale Wellenführung gestattet (sogenannte Indexguided-Laser). Zur Verstärkung dieses Effektes kann auch vor dem Aufbringen der Isolatorschicht die aktive InGaAsP-Schicht zu beiden Seiten des aktiven Streifens stufenförmig, bis hinunter zur p-InP-Schicht, abgeätzt werden. Man erhält dann eine Struktur, in der der aktive Laserstreifen oben und zu beiden Seiten von Materialien mit im Vergleich zur aktiven Laserschicht geringeren Brechungsindizes umgeben ist (sogenannter "vergrabener"(buried) Heterostrukturlaser).

Die aktive Schicht selbst kann a) p-dotiert und b)n-dotiert sein: Im Fall a) stellt dann die Grenzfläche CdO/aktive Schicht den injizierenden pn-Übergang dar. Im Fall b) liegt der pn-Übergang an der Grenzfläche p-InP/n-aktive Schicht, während der Übergang aktive Schicht/CdO einen quasi-ohmschen Kontakt bilden muß. Dies läßt sich hinreichend erreichen, wenn die n-Dotierung der aktiven Schicht hoch gewählt wird (z.B. Elektronenkonzentration größer als $5 \times 10^{17}$ cm$^{-3}$) und deren Bandabstand klein ist, was bei Lasern für 1,3 μm - und besonders für 1,5 μm - Emissionswellenlänge der Fall ist. Derartige Bauelemente können natürlich auch bei Betrieb unterhalb der Laserschwelle als kantenemittierende LED verwendet werden.

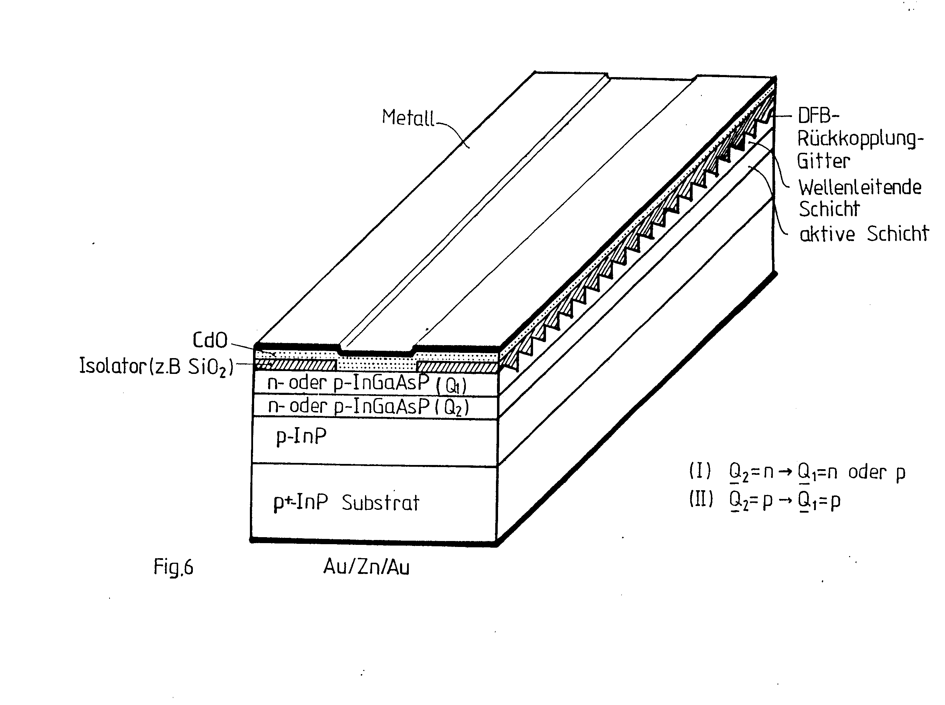

Die in Fig. 6 dargestellte Laserstruktur weist zwischen der aktiven Schicht $Q_2$ und der CdO-Schicht eine zusätzliche Wellenleiterschicht $Q_1$ aus einem Material auf, dessen Bandabstand größer ist als der des Materials der aktiven Schicht. Damit ergibt sich eine asymmetrische SCH-Struktur (Separate Confinement Heterostructure). Die Wellenleiterschicht $Q_2$ kann sowohl n- als auch p-dotiert sein; bei p-Dotierung erfolgt die Elektroneninjektion über diese Schicht hinweg in die aktive Schicht. Bei n-Dotierung muß ein quasi-ohmscher CdO/Halb-leiter (= Wellenleiterschicht)-Übergang erreicht werden.

Diese Struktur bietet vor allem für die Herstellung von DFB-Lasern (DFB = distributed Feedback) einen wichtigen Vorteil: Die Herstellung des erforderlichen optischen Rückkopplungsgitters erfolgt in der Wellenleiterschicht $Q_2$ auf übliche Weise. Auf dieses Gitter wird dann die CdO-Schicht aufgesputtert oder mit anderen, nicht-epitaxialen Verfahren (Aufdampfen, Gasphasenabscheideverfahren, Sprühverfahren u.a.)aufgebracht, so daß das herkömmliche Aufwachsen einer weiteren Epitaxieschicht in einem zweiten Epitaxieschritt, das sich als sehr kritisch erweist, entfallen kann. Die laterale Strukturierung der aktiven Zone erfolgt wie oben schon beschrieben, die Anordnung des Rückkontaktes aus Au/Zn/Au auf der Unterseite des Substrats.

Die im Zusammenhang mit den Fig. 5 und 6 erläuterten Laserstrukturen (mit Ausnahme der DFB-Struktur) können auch als optische Durchgangsverstärker eingesetzt werden. Hierzu sind reflexionsfreie entspiegelte Laserendflächen erforderlich.

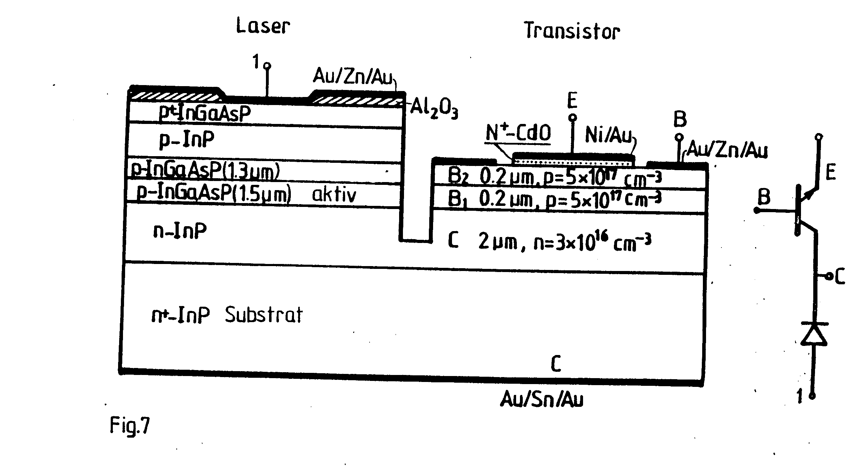

Die Fig. 7 zeigt zwei unterschiedliche Bauelemente, einen Laser und einen Transistor, in monolithischer Integration, sowie daneben das zugehörige Schaltbild. Die auf dem InP-Substrat aufgewachsenen Schichten für den Laser werden für die Ausbildung des Transistors teilweise wieder abgetragen. Es handelt sich dabei um die p-dotierte InGaAsP-Schicht (Kontaktschicht des Lasers) sowie um die darunter liegende p-InP-Schicht. Die aktive Schicht des Lasers aus p-InGaAsP sowie die Zwischenschicht aus demselben Material bilden für den Transistor das Basisgebiet $B_1$, $B_2$. Beide Bauelemente sind durch einen geätzten Graben G voneinander soweit getrennt, als dies ihre Zusammenschaltung erfordert. Das heißt, zwischen dem Anschluß 1 des Lasers und dem Emitter E des Transistors fließt der Strom über das gemeinsame, auf Kollektorpotential C liegende Substrat.

Über entsprechende Arbeiten wurde inzwischen z.B. von Su, Grote, Schmitt: "A diffused Planar InP Bipolar Transistor with a Cadmium Oxide Film Emitter", von Su, Grote, Kaumanns, Katzschner, Bach: "An InGaAsP/InP Double Heterojunction Bipolar Transistor for Monolithic Integration with a 1,5 μm Laser Diode" sowie als Vortrag anläßlich des "International Symposium on GaAs and Related Compounds" in Biaritz (Frankreich), Ende September 1984 von Su, Grote, Bach, Döldissen, Rosenzweig noch eingehender berichtet.

Diese Arbeiten sind ein Ergebnis von experimentell bereits bestätigten Untersuchungen, die zeigten, daß durch Aufsputtern einer CdO-Schicht auf p-dotiertes InP, $In_{0,53}Ga_{0,47}As$ und InGaAsP eine pn-Diode, d.h. ein elektrischer pn-Übergang, hergestellt werden kann. Der Beweis für die Existenz eines solchen Übergangs ergibt sich aus der Elektrolumineszenz, die durch Elektronen erzeugt werden, die bei Polung des pn-Übergangs in Fließrichtung vom CdO in den p-Halbleiter injiziert werden. Das Strom-Spannungs-Verhalten (I-V-Kurve) kann dabei mit der bekannten Gleichung für den pn-Übergang von Halbleitern beschrieben werden: $I = I_o \exp \left(\dfrac{U_a}{n\,kT}\right)$

($U_a$ = Vorwärtsspannung; T = Temperatur; n = Idealitätsfaktor). Der n-Faktor beschreibt die "Güte" des pn-Übergangs und beträgt im Idealfall n = 1, in III-V-Übergängen typisch zwischen n = 1...2. In den der vorliegenden Erfindung zugrundeliegenden Experimenten betrug n $\geq$ 1,2, was auf einen "guten" pn-Übergang hinweist.

Das CdO wurde in den Experimenten durch Hochfrequenz-Magnetron-Sputtern (für 13,56 MHz) von einem gesinterten CdO-Target deponiert. Der Druck des verwendeten Ar-Plasmas betrug 8 x $10^{-3}$ mbar. So hergestellte Schichten weisen folgende typische Eigenschaften auf:

spezifischer Widerstand:        2 x $10^{-4}$ Ωcm,
d.h. hohe elektrische Leitfähigkeit,

freie Elektronenkonzentration: ca. 3 x $10^{20}$ cm$^{-3}$

Elektronenbeweglichkeit:        etwa 100 $\frac{cm^2}{Vsec}$

Die optische Transparenz wurde gemessen im Wellenlängenbereich 0,54 µm < λ < 1,8 µm.

Aus der kurzwelligen Absorptionskante bei λ = 0,54 µm wird für das CdO ein direkter "optischer" Bandabstand von Eg $\cong$ 2,3 eV errechnet. In der Literatur wird jedoch berichtet, daß CdO ein indirekter Halbleiter ist und einen elektrischen Bandabstand von ~ 1,05 - 1,45 eV besitzt. Aufgrund eigener Untersuchungen an InP-Transistoren konnte jedoch gefolgert werden, daß der effektive Bandabstand mindestens $E_g$ > 1,25 eV betragen dürfte.

Aufgrund dieser Daten werden dem CdO Halbleitereigenschaften zugeschrieben und - obwohl nur von polykristalliner bis amorpher Struktur - wird dieses Oxidmaterial wie ein Halbleiter behandelt.

0173643

HEINRICH-HERTZ-INSTITUT FÜR NACHRICHTENTECHNIK BERLIN
GmbH                                          11/0884 EP

Patentansprüche

1. Halbleiterbauelement, das eine Schicht aus einem Material aufweist, welches optisch transparent, elektrisch leitfähig - n-leitend - und polykristallin bis
amorph ist,
g e k e n n z e i c h n e t   d u r c h
mindestens eine Schichtenfolge, in der eine monokristalline, p- oder n-dotierte Schicht aus InP-, InGaAs- oder
InGaAsP-Halbleitermaterial und die Schicht aus dem optisch transparenten, n-leitenden Material einen pn-
Übergang bzw. einen quasi-ohmschen Kontakt bilden.

2. Bauelement nach Anspruch 1,
g e k e n n z e i c h n e t   d u r c h
einen in Vorwärtsrichtung gepolten pn-Übergang.

3. Bauelement nach Anspruch 1,
g e k e n n z e i c h n e t   d u r c h
einen in Sperrichtung gepolten pn-Übergang.

4. Bauelement nach Anspruch 1,
g e k e n n z e i c h n e t   d u r c h
einen nicht vorgespannten pn-Übergang.

5. Bauelement nach Anspruch 1,
g e k e n n z e i c h n e t   d u r c h
eine Ausbildung als kantenemittierende Lumineszenzdiode, deren Lichtwellen emittierende Schicht aus dem monokristallinen Halbleitermaterial besteht und von einer Schicht aus dem transparenten, n-leitenden Material bedeckt ist, welches ein optisches und/oder elektrisches Confinement herbeiführt.

6. Bauelement nach Anspruch 1,
g e k e n n z e i c h n e t   d u r c h
eine Ausbildung als kantenemittierender Laser, dessen Lichtwellen emittierende Schicht aus dem monokristallinen Halbleitermaterial besteht und von einer Schicht aus dem transparenten, n-leitenden Material bedeckt ist, welches ein optisches und/oder elektrisches Confinement herbeiführt.

7. Bauelement nach Anspruch 1,
g e k e n n z e i c h n e t   d u r c h
eine Ausbildung als Laser, bei dem das monokristalline Halbleitermaterial eine sogenannte Wellenleiter-Zwischenschicht mit Confinement bildet, die sich zwischen der Lichtwellen emittierenden Halbleiterschicht und dem transparenten, n-leitenden Material befindet.

8. Bauelement nach einem der Ansprüche 1 bis 4,
g e k e n n z e i c h n e t   d u r c h
eine in ihrer Dicke d mit etwa $\lambda/4$ ausgebildete Schicht aus dem optisch transparenten Material so, daß diese Schicht entsprechend den Brechzahlen der begrenzenden Medien für einen spezifischen Wellenlängenbereich Reflexionen verhindert bzw. zumindest reduziert.

9. Bauelement nach einem der Ansprüche 1 bis 3,
g e k e n n z e i c h n e t   d u r c h
eine n-leitende, optisch transparente Schicht aus Cadmiumoxid - CdO -.

10. Bauelement nach einem der Ansprüche 1 bis 7,
g e k e n n z e i c h n e t   d u r c h
eine n-leitende, optisch transparente Schicht aus
Cadmiumzinnoxid (CTO) - $Cd(Sn)O$ -.

11. Bauelement nach einem der Ansprüche 1 bis 7,
g e k e n n z e i c h n e t   d u r c h
eine n-leitende, optisch transparente Schicht aus
Indiumzinnoxid (ITO) - $In_2(Sn)O_3$ -.

12. Verwendung von Bauelementen nach einem oder mehreren der Ansprüche 1 bis 11 für den Aufbau elektronischer und/oder opto-elektronischer, integrierter Schaltungen.

0173643

Fig.1

Fig.2

0173643

hν

Au/Zn/Au(B) Ni/Au(E) N⁺-CdO Emitter

p InGaAs Basis

n InGaAs Kollektor

n InP puffer

n⁺ InP Substrat

Au/Sn/Au (C)

Fig.3

Al₂O₃ Metall(E) N⁺CdO Emitter Au/Zn/Au (B)

p InP Basis(Zn diffundiert)

n InP Kollektor

n⁺ InP Substrat

Au/Sn/Au(C)

Fig.4

n=Brechungsindex

$n_{CdO}$   $n_{SiO_2}$

n

Metall

$n_{CdO}$

CdO oder ITO
Isolator(z.B SiO₂)

n, p-InGaAsP   aktiv

p-InP

p-InP   Substrat

Fig.5

Au/Zn/Au

Metall

DFB-
Rückkopplung-
Gitter
Wellenleitende
Schicht
aktive Schicht

CdO
Isolator(z.B SiO$_2$)

| n- oder p-InGaAsP ( Q$_1$) |
| n- oder p-InGaAsP ( Q$_2$) |
| p-InP |
| p$^+$-InP Substrat |

Au/Zn/Au

Fig.6

(I)  $\underline{Q}_2 = n \rightarrow \underline{Q}_1 = n$ oder p
(II) $\underline{Q}_2 = p \rightarrow \underline{Q}_1 = p$

Laser  Transistor

1  Au/Zn/Au

p⁺-InGaAsP → $p^+$-InGaAsP

p-InP

p-InGaAsP(1.3 µm)

p-InGaAsP(1.5 µm)  aktiv

n-InP

n⁺-InP Substrat → $n^+$-InP Substrat

C

Au/Sn/Au

$Al_2O_3$

E

$N^+$-CdO  Ni/Au

B

Au/Zn/Au

$B_2$  0.2 µm, $p = 5 \times 10^{17}$ cm⁻³

$B_1$  0.2 µm, $p = 5 \times 10^{17}$ cm⁻³

C  2 µm, $n = 3 \times 10^{16}$ cm⁻³

E

B

C

1

Fig.7

0173643